(19) Europäisches Patentamt
European Patent Office
Office européen des brevets

(11) EP 3 425 452 A1

(12) EUROPEAN PATENT APPLICATION
published in accordance with Art. 153(4) EPC

(43) Date of publication:
09.01.2019 Bulletin 2019/02

(51) Int Cl.:
G03F 7/20 (2006.01)          H01L 21/68 (2006.01)
H02K 9/19 (2006.01)

(21) Application number: 17759709.3

(22) Date of filing: 20.02.2017

(86) International application number:
PCT/JP2017/006096

(87) International publication number:
WO 2017/150243 (08.09.2017 Gazette 2017/36)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
MA MD

(30) Priority: 29.02.2016 JP 2016038128

(71) Applicant: Canon Kabushiki Kaisha
Tokyo 146-8501 (JP)

(72) Inventor: NOMOTO Makoto
Tokyo 146-8501 (JP)

(74) Representative: Garner, Jonathan Charles
Stapleton
Canon Europe Ltd
European Patent Department
3 The Square
Stockley Park
Uxbridge, Middlesex UB11 1ET (GB)

(54) DRIVE DEVICE, LITHOGRAPHY DEVICE, COOLING METHOD, AND METHOD FOR MANUFACTURING ARTICLE

(57) A drive unit 200 according to the present invention includes an electromagnetic actuator including a magnet 8 and a coil 10 and configured to drive an object 6 by allowing current to flow through the coil 10; a containing means for containing a first refrigerant 24 and the coil immersed in the first refrigerant in liquid state, the first refrigerant 24 cooling the coil 10 by evaporating from liquid state; condensing means 71 and 80 for condensing the first refrigerant 24 in gas state; and a detecting means 38 for detecting changes in the temperature or volume of the first refrigerant 24. The condensing means 71 and 80 include regulating means 32, 86, and 88 for regulating the condensation quantity of the first refrigerant 24 on the basis of the result of detection made by the detecting means 38.

FIG. 2

200

**Description**

Technical Field

The present invention relates to a drive unit, a lithography apparatus, a cooling method, and an article manufacturing method.

Background Art

In a drive unit including an electromagnetic actuator driven by a coil and a magnet, the coil generates heat when current flows through the coil. Therefore, for example, when the drive unit is mounted on a stage device of a lithography apparatus that transfers a pattern formed on a mask to a substrate, the temperature in the space surrounding the stage device varies. When a measuring instrument, such as a laser interferometer, is used to measure the position of the stage device, the temperature variation may cause errors in the position measurement.

Patent Literature (PTL) 1 discloses a technique related to cooling of a coil. A stator of a drive unit described in PTL 1 includes a first housing which is an airtight container containing a coil and a first refrigerant therein, and a second housing disposed on an upper surface of the first housing. The first refrigerant is a material in gas-liquid equilibrium, whereas a second refrigerant circulating in the second housing is a refrigerant temperature-regulated to a predetermined value. The first refrigerant evaporates while removing heat from the coil in contact with the first refrigerant in liquid state. By cooling the first refrigerant in gas state with the second refrigerant, the first refrigerant is turned into a liquid again.

Citation List

Patent Literature

PTL 1: Japanese Patent Laid-Open No. 2006-6050

Summary of Invention

Technical Problem

In PTL 1, the first refrigerant does not begin to condense until a temperature difference is created between the first housing and the second housing after gradual transfer of the heat the first refrigerant has removed from the coil to the upper surface of the first housing. The first refrigerant continues to evaporate until it begins to condense. Since changes in the pressure of the first refrigerant are more responsive than transfer of heat to the coil, the internal pressure of the first housing rises before the condensation begins.

The Clausius-Clapeyron equation representing the relation between vapor pressure and boiling point shows that as the vapor pressure increases, the boiling point of a liquid increases. That is, in the drive unit described in PTL 1, a rise in the internal pressure of the first housing leads to an increased boiling point of the first refrigerant. This means that until the internal pressure of the first housing is returned to the original level by condensation of the first refrigerant, the coil temperature easily rises and the occurrence of variation in coil temperature may be more likely.

The present invention has been made in view of the problems described above. An object of the present invention is to provide a drive unit, a lithography apparatus, and a cooling method that can reduce variation in coil temperature.

Solution to Problem

A drive unit according to the present invention includes an electromagnetic actuator including a magnet and a coil and configured to drive an object by allowing current to flow through the coil; a containing means for containing a first refrigerant and the coil immersed in the first refrigerant in liquid state, the first refrigerant cooling the coil by evaporating from liquid state; a condensing means for condensing the first refrigerant in gas state; and a detecting means for detecting changes in temperature or volume of the first refrigerant. The condensing means includes a regulating means for regulating a condensation quantity of the first refrigerant on the basis of a result of detection made by the detecting means.

Brief Description of Drawings

[Fig. 1] Fig. 1 illustrates a configuration of a stage device and an interferometer according to a first embodiment.
[Fig. 2] Fig. 2 illustrates a configuration of a drive unit according to the first embodiment.
[Fig. 3] Fig. 3 illustrates a configuration of a drive unit according to a second embodiment.
[Fig. 4] Fig. 4 illustrates a configuration of a drive unit according to a third embodiment.
[Fig. 5] Fig. 5 illustrates a configuration of a drive unit according to a fourth embodiment.
[Fig. 6] Fig. 6 illustrates a configuration of a lithography apparatus according to a fifth embodiment. Description of Embodiments

[First Embodiment]

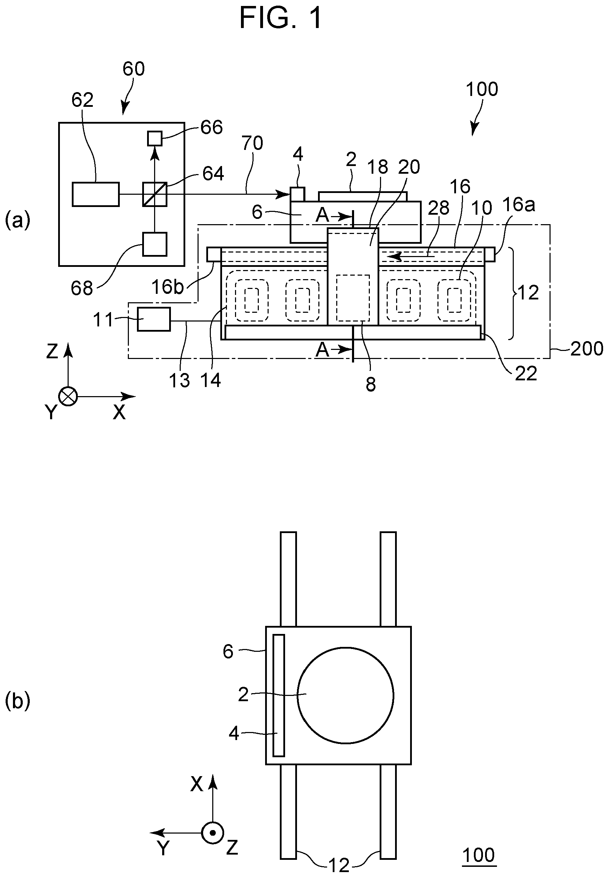

Fig. 1(a) is a front view illustrating a configuration of a stage device (positioning device) 100 and an interferometer 60 that measures the position of the stage device 100 according to a first embodiment. Fig. 1(b) illustrates the stage device 100 as viewed from the positive side in the Z-direction. An axis in the vertical direction is a Z-axis, and two axes orthogonal to each other in a plane perpendicular to the Z-axis are an X-axis and a Y-axis.

The stage device 100 is a device that determines the position of an object 2. The stage device 100 includes a stage (object) 6 having the object 2 and a mirror 4 thereon, and a drive unit 200 configured to drive the stage 6. The mirror 4 extends in the Y-axis direction and reflects a measurement beam from the interferometer 60.

The drive unit 200 includes an electromagnetic actuator including a magnet 8 and a coil 10 and configured to be driven by allowing current to flow through the coil 10. The electromagnetic actuator according to the present embodiment is of a moving magnet type in which a plurality of coils 10 serve as a stator 12 of the drive unit 200 and a plurality of magnets 8 serve as a movable element 18 (not shown in Fig. 1(b)) of the drive unit 200. The movable element 18 moves along the X-axis direction, which is a direction in which the plurality of coils 10 are arranged.

For the stage 6, the stage device 100 includes two stators 12 (see Fig. 1(b)) and two movable elements 18 arranged parallel to each other. With this configuration, the stage device 100 moves the object 2 while restricting a tilt in the direction of rotation about the Z-axis.

Each movable element 18 includes two magnets 8 disposed to face a corresponding one of the stators 12 (i.e., located on the negative and positive sides in the Y-direction with respect to the stator 12) and one yoke 20 connected to the two magnets 8. Note that in Fig. 1(a), the magnet on the positive side in the Y-direction is not shown. When current sequentially flows through coils 10 at predetermined positions, the movable elements 18 are moved in the X-axis direction while being guided by a guide 22. As the movable elements 18 move, the stage 6 connected to the movable elements 18 moves in the X-axis direction.

The drive unit 200 also includes a current source 11, which supplies current through a wire 13 to the coil 10 at a predetermined position in accordance with a target position of the stage 6.

The stators 12 each include a first housing (first containing means) 14 containing a plurality of coils 10 and a second housing 16 disposed above the first housing 14.

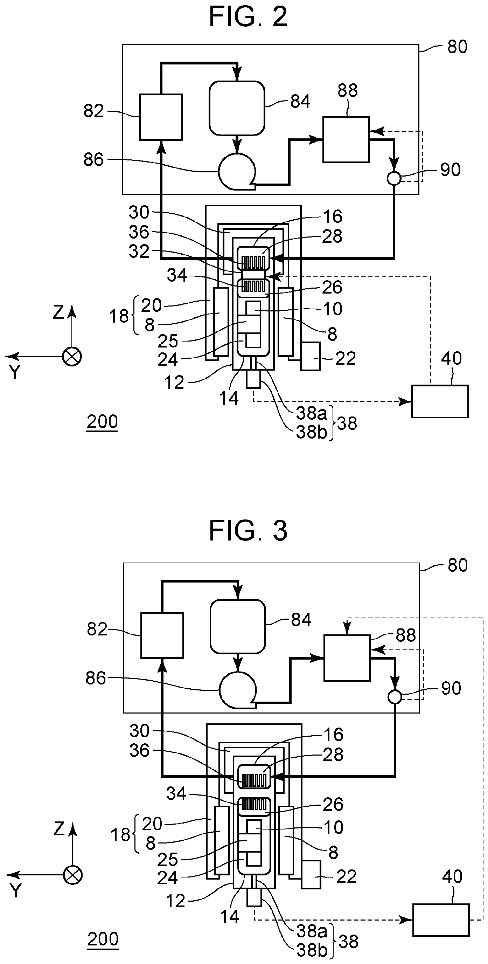

The configuration of the first housing 14 will be described in detail later on. The second housing (second containing means) 16 is a housing extending along the first housing and containing a refrigerant 28 therein. The second housing 16 has a supply port 16a at one end thereof for supplying the refrigerant 28, and a discharge port 16b at the other end thereof for discharging the refrigerant 28. The refrigerant 28 circulates inside the second housing 16 and along the flow path of a circulating system 80 (shown in Fig. 2). That is, the refrigerant 28 flows through a system independent of a refrigerant 24 (described in detail below) supplied to the first housing.

The interferometer 60 includes a light source 62, a beam splitter 64, a reference mirror 66, and a detector 68. A laser beam 70 emitted from the light source 62 is divided by the beam splitter 64 into a beam directed toward the reference mirror 66 and a beam directed toward the mirror 4 for measurement. The beam splitter 64 causes the beam reflected by the reference mirror 66 and the beam reflected by the mirror 4 to enter the detector 68. The detector 68 measures the X-position of the stage 6 by measuring the intensity of an interference pattern formed by superimposition of the beams.

Fig. 2 illustrates a configuration of the drive unit 200 according to the first embodiment. Specifically, Fig. 2 illustrates the configuration as viewed in the direction of arrows A-A in Fig. 1(a) and the circulating system 80 not shown in Fig. 1(a).

The drive unit 200 includes a condensing means for condensing the refrigerant 24 evaporated into gas state. The condensing means includes a regulating means for regulating the condensation quantity of the refrigerant 24 on the basis of the result of detection made by a detecting means 38. The detecting means 38 detects changes in the state of the refrigerant 24 in gas state. The detecting means 38 will be described later on.

The regulating means is a means for regulating heat of the refrigerant 24 in gas state in at least one of the interior of the first housing 14 and a space (communicating space) communicating with the interior of the first housing 14.

The condensing means according to the present embodiment condenses the refrigerant 24 using the refrigerant 28 flowing through the system independent of the refrigerant 24. The condensing means includes the circulating system 80 and a Peltier element 32 serving as the regulating means. The Peltier element 32 dissipates heat in the first housing 14 to the flow path of the refrigerant 28. The phrase "flowing through the system independent of the refrigerant 24" means that the refrigerant 28 flows through a space separated from the space where the refrigerant 24 flows. The condensing means may also include a condensing fin 34 and a heat dissipating fin 36.

The first housing 14 contains the refrigerant (first refrigerant) 24 for cooling the coil 10 by evaporating from liquid state, and the coil 10 immersed in the refrigerant 24 in liquid state.

The interior of the first housing 14 is an enclosed space sealed to allow little transfer of a gas into and out of the first housing 14. When a sealing member, such as an O-ring, is used, a wire (not shown) connected to the detecting means 38 (described below) or the wire 13 may be connected to the interior of the first housing 14, or the first housing 14 may have an openable and closable opening (not shown) for introducing therein a predetermined amount of the refrigerant 24.

The refrigerant 24 has a boiling point close to a control temperature in the environment where the stage device 100 is used. The refrigerant 24 exists in liquid-gas equilibrium. When the coil 10 generates heat, the coil 10 can be immediately cooled by evaporation of the refrigerant 24. The refrigerant 24 in gas state exists in a space 26 on the upper side in the interior of the first housing 14. In the present specification, only the refrigerant 24 in liquid state is denoted by reference numeral 24.

The refrigerant 24 is preferably a refrigerant with low electrical conductivity, because it directly contacts the coil 10. With the refrigerant with low electrical conductivity, the coil 10 can be prevented from short-circuiting.

When the control temperature is around room temperature, the refrigerant 24 used here may be water, alcohol, ether, hydrofluoroether (hereinafter referred to as HFE), or Fluorinert.

If the refrigerant 24 does not evaporate in an atmospheric pressure environment, the space 26 may be depressurized in advance. This can lower the boiling point of the refrigerant 24. For example, when HFE is used in a 23°C environment, the space 26 is depressurized to about 60 kPa (abs). This allows HFE in gas-liquid equilibrium to be charged into the first housing 14.

The first housing 14 further contains a support member 25 for supporting the coil 10 and the condensing fin 34 (described below).

An insulating member 30 made of a heat insulating material is disposed outside the second housing 16 and adjacent to the movable element 18. Even when heat of the stator 12 varies, it is possible to prevent (or reduce) transfer of heat to the movable element 18 or to the object 2. The second housing 16 itself may be made of a heat insulating material. For example, foamed plastic, such as polystyrene or polyurethane, or glass wool may be used as the heat insulating material.

The circulating system 80 has a mechanism for circulating the refrigerant 28 such that the temperature-regulated refrigerant 28 is supplied to the supply port 16a, and then the refrigerant 28 discharged from the discharge port 16b is collected and supplied again to the supply port 16a. The refrigerant 28 may be a material in either liquid or gas state at the control temperature of the stage device 100.

The circulating system 80 includes a cooler 82, a tank 84, a pump 86, a heat exchanger 88, and a sensor 90 that measures the temperature of the heat exchanger 88. The cooler 82 temporarily cools the refrigerant 28 collected from the second housing 16. Exhaust heat generated during cooling is dumped to the outside of the circulating system 80. The refrigerant 28 cooled by the cooler 82 is temporarily stored in the tank 84. The pump 86 delivers the refrigerant 28 in the tank 84 to the heat exchanger 88 in predetermined amounts per unit time.

The sensor 90 measures the temperature of the refrigerant 28 regulated by the heat exchanger 88. The heat exchanger 88 regulates the temperature of the refrigerant 28 such that the temperature measured by the sensor 90 is a predetermined temperature.

The circulating system 80 may be of any type capable of supplying the temperature-regulated refrigerant 28 to the second housing 16 and does not necessarily need to be a system for circulating the refrigerant 28.

The Peltier element 32 is disposed at the joint between the first housing 14 and the second housing 16. The Peltier element 32 is an element capable of transferring heat from one to the other of the interior of the first housing 14 and the interior of the second housing 16 (i.e., second refrigerant). Particularly in the present embodiment, heat calculated by a controller 40 (described below) on the basis of the result of detection made by the detecting means 38 is transferred from the refrigerant 28 to the first housing 14 in accordance with an instruction from the controller 40.

The Peltier element 32 may be disposed inside the first housing 14 and adjacent to the second housing 16 or may be disposed inside the second housing 16 and adjacent to the first housing 14.

The condensing fin 34 is disposed on the side of the first housing 14 adjacent to the Peltier element 32, and the heat dissipating fin 36 of the same shape as the condensing fin 34 is disposed on the side of the second housing 16 adjacent to the Peltier element 32. The condensing portion of the condensing fin 34 and the heat dissipating portion of the heat dissipating fin 36 are disposed to face the Peltier element 32 in directions opposite each other. The condensing fin 34 is a part where the condensed refrigerant 24 is collected. The heat dissipating fin 36 is a part where heat transferred from the interior of the first housing 14 by the Peltier element 32 is dissipated into the refrigerant 28.

Both the condensing fin 34 and the heat dissipating fin 36 are preferably formed by a plurality of needle-like portions as illustrated in Fig. 2. This provides a large area in contact with the evaporated refrigerant 24 and improves efficiency of condensation. With the heat dissipating fin 36, the efficiency of transfer of exhaust heat to the second refrigerant is improved. To simplify the explanation, the condensing fin 34 and the heat dissipating fin 36 are described as having the same shape in the present embodiment, but they may have different shapes.

The detecting means 38 according to the present embodiment is a means of detecting changes in the pressure of the refrigerant 24 in gas state. The detecting means 38 includes a sensor 38a and a calculator 38b. The sensor 38a is disposed at the inner bottom of the first housing 14. The sensor 38a measures a pressure received from the refrigerant 24 in liquid state and varying in accordance with changes in the pressure of the refrigerant 24 in gas state. The calculator 38b connected to the sensor 38a calculates a difference between the pressure detected by the sensor 38a and a predetermined pressure. The predetermined pressure refers to the saturation vapor pressure of the refrigerant 24 in a state where no current flows through the coil 10 (hereinafter referred to as idle state). Note that the function of the calculator 38b may be included in the controller 40.

The controller 40 includes a CPU and a memory (including a ROM and a RAM). The controller 40 is connected to the detecting means 38. On the basis of the result of detection made by the detecting means 38, the controller 40 determines the quantity of heat corresponding to the amount of the refrigerant 24 to be condensed (hereinafter referred to as a target condensation quantity) to reduce variation in the temperature of the coil 10. Additionally, on the basis of the target condensation quantity, the controller 40 determines the quantity of heat to be transferred from the second refrigerant 6 to the first housing 14 by the Peltier element 32.

The target condensation quantity is preferably the condensation quantity for reducing changes in pressure detected by the detecting means 38 (i.e., for bringing the amount of change close to zero). The following describes how the target condensation quantity is to be calculated when the Peltier element 32 transfers heat corresponding to changes in pressure detected by the detecting means 38.

The volume of the first housing 14 is denoted by V, the density of the refrigerant 24 in gas state is denoted by $\rho$ [g/l], the internal pressure of the first housing 14 in idle state is denoted by P0 [Pa], and the volume of the gaseous refrigerant 24 in idle state is denoted by Vg. The values of V, p, Vg, P0, and the latent heat L [J/g] of the refrigerant 24 are stored in advance in the memory of the controller 40. The amount of change in pressure measured by the sensor 38a is denoted by P [Pa], the amount of the refrigerant 24 evaporated as the pressure changes from the pressure P0 to the pressure P is denoted by $\Delta m$ [g], and P0 - P = $\Delta P$. If the amount of the refrigerant 24 evaporated is too small to change the volume V1 of the refrigerant 24, "Vg = V - V1 = constant" is satisfied.

In idle state, the amount G of the refrigerant 24 in gas state is expressed by equation (1):

$$G = P \cdot Vg \cdot \rho / P0 \; [g] \;\; \cdots \; (1)$$

Using the Boyle's law allows the following equation (2) to be satisfied:

$$(P+\Delta P) \cdot Vg = \{P0 \cdot Vg \cdot (\rho+\Delta m)\}/\rho \;\; \cdots \; (2)$$

The target condensation quantity M [g], which is equal to $\Delta m$, is expressed by equation (3) using equations (1) and (2) :

$$M = \Delta m = \rho \cdot vg \cdot \Delta P / P0 \;\; \cdots \; (3)$$

The heat quantity Q [J] representing the amount of heat to be transferred by the Peltier element 32 is expressed by equation (4) using the latent heat L [J/g]:

$$Q = M \cdot L = \rho \cdot vg \cdot \Delta P \cdot L / P0 \;\; \cdots \; (4)$$

(Cooling Method)

A method for cooling the coil 10 in the drive unit 200 will now be described. To drive the drive unit 200, the current source 11 begins to supply current to the coil 10. While the current flows, the detecting means 38 detects the pressure of the refrigerant 24 continuously or at predetermined time intervals. When the coil 10 generates heat, the refrigerant 24 evaporates to cool the coil 10. When the sensor 38a for the refrigerant 24 detects a rise in pressure in response to an increase in the amount of the refrigerant 24 in gas state, the calculator 38b calculates a difference between the detected pressure and a predetermined pressure. The detecting means 38 sends the calculated change in pressure to the controller 40.

On the basis of equation (4), the controller 40 calculates the heat quantity Q representing the amount of heat to be transferred by the Peltier element 32 and sends the calculated heat quantity Q to the Peltier element 32. The Peltier element 32 transfers heat represented by the heat quantity Q, and this condenses the refrigerant 24.

The refrigerant 24 turned into a gas in the interior of the first housing 14 is condensed into a liquid again. This returns the internal pressure of the first housing 14 to the predetermined pressure. When the detecting means 38 detects that the internal pressure of the first housing 14 has fallen below the predetermined pressure, the Peltier element 32 may transfer heat in the interior of the first housing 14 to the second refrigerant to reduce the condensation quantity.

The controller 40 does not necessarily need to hourly calculate the heat quantity Q as long as it can acquire the heat quantity Q. The controller 40 may determine the heat quantity Q on the basis of the correlation between the change in pressure calculated by the calculator 38b and the heat quantity Q. The controller 40 may perform follow-up control of the regulation of condensation quantity by using PID control.

Thus, in the drive unit 200, the Peltier element 32 regulates the condensation quantity of the refrigerant 24 on the basis of the result of detection made by the detecting means 38. By regulating the condensation quantity, it is possible to keep the pressure of the refrigerant 24 and the boiling point of the refrigerant 24 at predetermined values and suppress a rise in the temperature of the coil 10 caused by a rise in the boiling point of the refrigerant 24. With the drive unit 200 and the cooling method of the present embodiment, variation in the temperature of the coil 10 can be made smaller than that when the condensation quantity of the refrigerant 24 is not regulated using the detecting means 38 and the Peltier element 32.

Generally, changes in the pressure of a gas are transmitted to a location at a predetermined distance faster than transmission of heat through space by the predetermined distance. That is, in the present embodiment, a change in the pressure of the refrigerant 24 is more responsive than the speed at which heat corresponding to a rise in the temperature of the coil 10 is transmitted through the space 26 to the refrigerant 28. The refrigerant 24 is condensed on the basis of the pressure change which is more responsive. Therefore, as compared to the drive unit described in PTL 1 in which changes in the state of the refrigerant 24 are not detected by a detecting means, it is possible to more effectively suppress a rise in the boiling point of the refrigerant 24 and reduce variation in the temperature of the coil 10.

It is thus possible to reduce propagation of heat from the coil 10 to the space having the stage device 100 therein, and reduce deterioration of measurement accuracy caused by temperature variation on the optical path of the laser beam 70. It is also possible to reduce propagation of heat through the movable element 18 to the stage 6 and reduce temporary deformation of the object 2.

The sensor 38a does not necessarily need to be disposed at the bottom of the first housing 14. For example, the sensor 38a may be disposed in the space 26. Since the Peltier element 32 is capable of dissipating heat in the first housing 14 to the outside of the first housing 14, the circulating system 80 including the flow path of the refrigerant 28 may be removed.

In the drive unit 200, the first housing 14 may include therein a stirring member for stirring the refrigerant 24. The stirring member may be a rotatable member with blades or may be a rotatable spherical member with holes. It is preferable to select a stirring member that generates less heat. When air bubbles produced by evaporation of the refrigerant 24 adhere to the coil 10, the contact area between the refrigerant 24 and the coil 10 is reduced. This can be avoided by stirring the refrigerant 24.

Instead of the interferometer 60, an encoder (not shown) may be used to detect the position of the stage device 100. This can reduce temperature variation at a portion for holding the encoder and an encoder scale, and can also reduce deterioration of accuracy in measuring the position of the stage device 100.

[Second Embodiment]

Fig. 3 illustrates a configuration of a drive unit 300 according to a second embodiment. A condensing means of the present embodiment also condenses the refrigerant 24 using the refrigerant 28 that flows through a system independent of the refrigerant 24. The drive unit 300 differs from the drive unit 200 in that as a regulating means, the drive unit 300 uses a temperature control means for controlling the temperature of the refrigerant 28, instead of the Peltier element 32. The other configurations of the drive unit 300 will not be described, as they are the same as those of the drive unit 200. Note that the heat exchanger 88 serves as the temperature control means in the circulating system 80.

A method for cooling the coil 10 in the drive unit 300 is as follows.

A pressure detected by the detecting means 38 is sent to the controller 40, which determines the temperature of the refrigerant 28 flowing inside the second housing 16. The controller 40 sets the determined temperature for the heat exchanger 88. The refrigerant 28 flowing through the second housing 16 and whose pressure has been detected by the detecting means 38 is regulated to a lower temperature.

When the heat exchanger 88 lowers the temperature of the refrigerant 28, the temperature in the second housing 16 falls below that in the first housing 14. Therefore, transfer of heat from the first housing 14 to the refrigerant 28 can increase the condensation of the refrigerant 24. Thus, the changed pressure of the refrigerant 24 can be brought closer to, or made equal to, the pressure in idle state. When the pressure change detected by the detecting means 38 no longer exists, the temperature set for the heat exchanger 88 is returned to the original value by the controller 40.

The temperature of the refrigerant 28 determined by the controller 40 may be lower by a predetermined temperature than that before the detecting means 38 detects a change in pressure, or may be varied in accordance with a change in pressure detected by the detecting means 38.

Thus, in the drive unit 300, the heat exchanger 88 regulates the condensation quantity of the refrigerant 24 on the basis of the result of detection made by the detecting means 38. By regulating the condensation quantity, it is possible to keep the pressure of the refrigerant 24 and the boiling point of the refrigerant 24 at predetermined values and suppress a rise in the temperature of the coil 10 caused by a rise in the boiling point of the refrigerant 24. With the drive unit 300 and the cooling method of the present embodiment, variation in the temperature of the coil 10 can be made smaller than that when the condensation quantity of the refrigerant 24 is not regulated using the detecting means 38 and the heat exchanger 88.

It is thus possible to reduce propagation of heat from the coil 10 to the space having the stage device 100 therein, and reduce deterioration of measurement accuracy caused by temperature variation on the optical path of the laser beam 70. It is also possible to reduce propagation of heat through the movable element 18 to the stage 6 and reduce temporary deformation of the object 2.

In the present embodiment, a larger quantity of heat than in the case of using the Peltier element can be transferred from the interior of the first housing 14 to the interior of the second housing 16. Therefore, the drive unit 300 is particularly suitable for use as a drive unit for the stage device where a large amount of current flows through the coil 10. For example, if the stage device 100 includes a fine-motion stage and a coarse-motion stage which moves by a larger amount than the fine-motion stage, the drive unit 300 is preferably used as a drive unit for the coarse-motion stage.

[Third Embodiment]

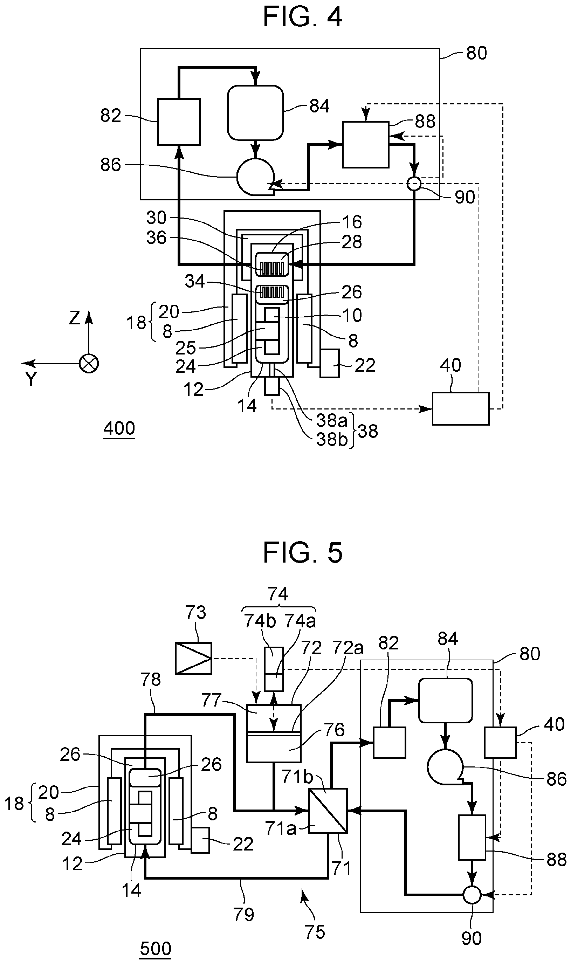

Fig. 4 illustrates a configuration of a drive unit 400 according to a third embodiment. A condensing means of the present embodiment also condenses the refrigerant 24 using the refrigerant 28 that flows through a system independent of the refrigerant 24. The drive unit 400 differs from the drive unit 300 in that as a regulating means, the drive unit 400 uses not only the heat exchanger 88 but also a flow rate control means for controlling the flow rate of the refrigerant 28. The other configurations of the drive unit 400 will not be described, as they are the same as those of the drive unit 300. Note that the pump 86 serves as the flow rate control means in the circulating system 80.

A method for cooling the coil 10 in the drive unit 400 is as follows.

A pressure detected by the detecting means 38 is sent to the controller 40, which determines the flow rate of the refrigerant 28 flowing inside the second housing 16. The controller 40 instructs the heat exchanger 88 to set the temperature of the refrigerant 28 lower by a predetermined temperature, and instructs the pump 86 to increase the flow rate of the refrigerant 28 flowing through the second housing 16. The temperature in the second housing 16 falls below that in the first housing 14, and this allows heat to be transferred from the first housing 14 to the refrigerant 28.

When the pressure change detected by the detecting means 38 no longer exists, the temperature set for the heat exchanger 88 and the flow rate of the refrigerant 28 set for the detector 68 are returned to the original values by the controller 40.

The drive unit 400 has the same effect as the second embodiment. Additionally, by using the pump 86, the condensation quantity of the refrigerant 24 per unit time can be made greater than that when the condensation quantity is regulated by using only the heat exchanger 88 and the sensor 90.

[Fourth Embodiment]

Fig. 5 illustrates a configuration of a drive unit 500 according to a fourth embodiment. Unlike the drive unit 300, the drive unit 500 does not include the second housing 16, the condensing fin 34, and the heat dissipating fin 36. Instead, the drive unit 500 includes a condenser 71, a cylinder 72, a pressure controller 73, a detecting means 74, and a space 75 communicating with the interior of the housing 14. A condensing means of the present embodiment also condenses the refrigerant 24 using the refrigerant 28 that flows through a system independent of the refrigerant 24. The condensing means of the present embodiment includes the condenser 71 and the circulating system 80 that circulates the refrigerant 28. The regulating means of the present embodiment is the heat exchanger 88.

A piston 72a separates a space 76 which is part of the space 75, and a space 77 whose pressure is controlled by the pressure controller 73.

The space 75 is back-pressured to a predetermined pressure by the pressure controller 73.

The predetermined pressure is the saturation vapor pressure (predetermined pressure) of the refrigerant 24 at a control temperature in the first housing 16. That is, the predetermined pressure is the internal pressure of the housing 16 during the period in which the coil 10 generates no heat (i.e., while no current flows through the coil 10). The pressure controller 73 is preferably, for example, a pressure regulating valve capable of regulating the input and output of compressed air to and from the space 77.

Thus, as the evaporation of the refrigerant 24 progresses, the position of the piston 72a moves to maintain pressures in the space 76 and the space 77. That is, the space 75 is a volume-variable space whose volume varies in accordance with the volume of the refrigerant 24.

The refrigerant 24 performs mechanical work which involves moving the piston 72a against back pressure.

The refrigerant 24 is preferably charged by an amount which makes the volumes of the space 75 and the space 76 substantially the same in idle state. While the piston 72a is moving, this prevents the piston 72a from hitting the inner wall of the cylinder 72 and allows the heat of the refrigerant 24 to continue to be converted into mechanical work.

The space 75 includes a pipe 78 communicating with the upper part of the interior of the housing 14 and allowing passage of the refrigerant 24 in gas state, the space 76, a space 71a allowing passage of the refrigerant 24 in the condenser 71, and a pipe 79 communicating with the lower part of the interior of the housing 14 and allowing passage of the refrigerant 24 condensed into liquid state.

The condenser 71 is divided into the space 71a where the refrigerant 24 flows and a space 71b where the refrigerant 28 flows. The condenser 71 exchanges (or transfers) heat between the refrigerant 28 and the space 75. The condenser 71 is, for example, a heat pump.

The detecting means 74 includes a sensor 74a that detects the position of the piston 72a, and a calculator 74b that calculates a difference between the position detected by the sensor 74a and a reference position. The calculator 74b inputs the result of calculation to the controller 40. That is, by detecting the change in the position of the piston 72a, the detecting means 74 detects the change in the state of the refrigerant 24 in gas state, specifically, the change in the volume of the first refrigerant. Note that the reference position refers to the position of the piston 72a in idle state.

On the basis of the result of detection made by the detecting means 74, the controller 40 determines the temperature of the refrigerant 28 flowing inside the second housing 16. The controller 40 sets the determined temperature for the heat exchanger 88.

By regulating the temperature of the refrigerant 28, the heat exchanger 88 regulates the condensation quantity of the refrigerant 24 condensed in the condenser 71.

(Cooling Method)

When the coil 10 generates heat by passage of current therethrough, the refrigerant 24 in contact with the coil 10 absorbs the heat of the coil 10 and evaporates. The evaporation of the refrigerant 24 may lead to increased pressure of the refrigerant 24. At this point, however, the refrigerant 24 in gas state adiabatically expands while moving the piston 72a. This suppresses an increase in the pressure of the refrigerant 24 and a rise in boiling point associated with the increase in the pressure of the refrigerant 24.

Since there is an upper limit to the volume of the space in the cylinder 72, it is necessary to prompt the condensation of the refrigerant 24. Accordingly, on the basis of the result of detection made by the detecting means 74, the controller 40 determines the temperature of the refrigerant 28 flowing inside the second housing 16 such that the volume of the refrigerant 24 is returned to the volume in idle state. The controller 40 sets the determined temperature for the heat exchanger 88.

The controller 40 may determine a target condensation quantity and a set temperature corresponding to the target condensation quantity on the basis of the calculation described below, or may set a predetermined temperature.

A method for calculating a target condensation quantity will now be described. A target condensation quantity C2 is expressed by equation (2):

$$C2 = (P \cdot A \cdot \Delta x / \Delta t) / L \ [g/sec] \ \cdots \ (2)$$

where L [J/g] is the latent heat of the refrigerant 24, A is the back-pressure area of the piston 72a, P is the pressure in the space 77, and the piston is moved by $\Delta x$ in a very small time period $\Delta t$.

The controller 40 calculates the set temperature of the refrigerant 28 corresponding to the target condensation quantity, and the heat exchanger 88 lowers the temperature of the refrigerant 28 in response to an instruction from the controller 40. This can increase the condensation quantity of the refrigerant 24 in the condenser 71 and bring the changed volume of the refrigerant 24 closer or equal to the volume in idle state. As the volume of the refrigerant 24 decreases, the position of the piston 72a becomes closer to the reference position. When the volume change detected by the detecting means 74 no longer exists, the temperature set for the heat exchanger 88 is returned to the original value by the controller 40.

When the detecting means 38 detects that the volume of the refrigerant 24 has fallen below that in idle state, the temperature set for the heat exchanger 88 may be raised to regulate the condensation quantity.

Thus, in the drive unit 500, the heat exchanger 88 regulates the condensation quantity of the refrigerant 24 on the basis of the result of detection made by the detecting means 74. By regulating the condensation quantity, it is possible to keep the pressure of the refrigerant 24 and the boiling point of the refrigerant 24 at predetermined values and suppress a rise in the temperature of the coil 10 caused by a rise in the boiling point of the refrigerant 24. With the drive unit 500 and the cooling method of the present embodiment, variation in the temperature of the coil 10 can be made smaller than that when the condensation quantity of the refrigerant 24 is not regulated using the detecting means 74 and the heat exchanger 88.

It is thus possible to reduce propagation of heat from the coil 10 to the space having the stage device 100 therein, and reduce deterioration of measurement accuracy caused by temperature variation on the optical path of the laser beam 70. It is also possible to reduce propagation of heat through the movable element 18 to the stage 6 and reduce temporary deformation of the object 2.

In the drive unit 500, the refrigerant 24 performs mechanical work which involves moving the piston 72a against back pressure. Thus, heat removed from the coil 10 can be converted to mechanical work and consumed. The amount of exhaust heat in the circulating system 80 can thus be made smaller than that in the first to third embodiments.

Since the refrigerant 24 is condensed in the space 75, the heat of the refrigerant 24 can be released at a distance from the movable element 18. This prevents easy transfer of heat to the stage 6, which moves together with the movable element 18. Additionally, since the position of the space 75 can be flexibly determined, the second housing 16 does not need to be positioned in a small space as in the first to third embodiment, and a higher degree of freedom in designing the drive unit is achieved.

As a regulating means for regulating the condensation quantity, the Peltier element 32 may be used as in the first embodiment, or the pump 86 may be used as in the third embodiment. Both the Peltier element 32 and the pump 86 may be used where appropriate.

[Fifth Embodiment]

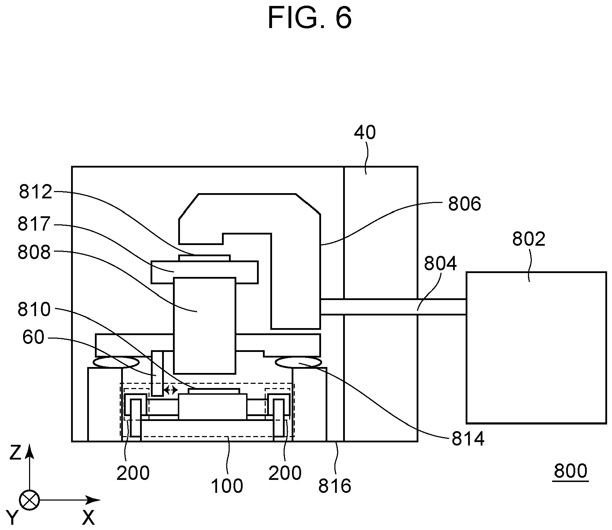

Fig. 6 illustrates a configuration of a lithography apparatus 800 including the stage device 100 having the drive unit 200 mounted thereon. The lithography apparatus 800 is an exposure apparatus that exposes a substrate 810 to light.

As a pattern forming unit that forms a pattern on the substrate 810, the lithography apparatus 800 includes a light source 802, an illumination optical system 806, and a projection optical system 808.

A KrF excimer laser beam (with a wavelength of 248 nm) emitted from the light source 802 passes through a light guiding member 804, the illumination optical system 806, and the projection optical system 808 and is applied to the substrate 810 (target object) placed on the stage device 100. A pattern (e.g., circuit pattern) formed on a reticle (mask) 812 is projected in a reduced size onto the substrate 810 by the projection optical system 808. The pattern on the reticle 812 is thus transferred onto the substrate 810.

The stage device 100 determines the position of the substrate 810, which is also the object 2 described above. The interferometer 60 measures the position of the substrate 810 by measuring the position and attitude of the stage 6. A mount 814 is an anti-vibration unit by which vibration from a mounting surface 816 is prevented from being transmitted to a support member that supports the projection optical system. The stage device 100 determines the position of the reticle 812.

On the basis of the measurement made by the interferometer 60, the controller 40 controls the positioning of the reticle 812 and the substrate 810.

As in the first embodiment, the stage device 100 can suppress heat generation of the coil 10. This can prevent transfer of heat generated in the coil 10 to the substrate and reduce degradation of overlay accuracy caused by deformation of the substrate. It is also possible to reduce degradation of positioning accuracy of the stage device 100 caused by variation in air temperature on the optical path of the interferometer 60.

The drive unit 200 may be mounted on a stage device 817 that moves the reticle 812. Any of the drive units 300, 400, and 500 or a drive unit produced by appropriately combining them may be mounted on the stage device 100 or stage device 817.

The lithography apparatus 800 is not limited to that described above. The lithography apparatus 800 may be any of various types of exposure apparatuses that form a pattern by exposing a substrate to a light beam, such as a g-line (with a wavelength of 436 nm), ArF laser light (with a wavelength of 193 nm), or EUV light (with a wavelength of 13 nm). The lithography apparatus 800 may be an imprint apparatus that forms a cured resist pattern using a mold with a three-dimensional pattern, or may be a drawing apparatus that draws a pattern by irradiating a substrate with charged particle beams.

[Other Embodiments]

Two or more of the first, second, and third embodiments may be carried out in combination. For example, as a regulating means for regulating the condensation quantity of the refrigerant 24, both the temperature control means of the second embodiment and the flow rate control means of the third embodiment may be used. The drive units 200, 300, 400, and 500 may include a plurality of first housings 14, and each of the first housings 14 may include one coil 10.

The number of coils 10 contained in one first housing 14 does not necessarily need to be the number of all coils 10 included in the stator 12. The stator 12 may be formed by a series of first housings 14 each containing one or a predetermined number of coils 10. The Peltier element 32 does not necessarily need to be one long Peltier element 32 provided for all the coils 10. The Peltier element 32 may be provided for the yoke 20 and each, or each predetermined number, of coils 10. When a plurality of first housings 14 are provided, at least as many Peltier elements 32 as the first housings 14 are required.

The controller 40 does not necessarily need to calculate the target condensation quantity each time. If the controller 40 has a table relating to the target condensation quantity corresponding to a change in pressure or volume, the controller 40 may determine the target condensation quantity from the table.

The controller 40 may be either a collection of different control substrates or a single control substrate, as long as it has all functions executed by the controller 40.

Besides the detecting means 38 and 74, the means for detecting changes in the state of the refrigerant 24 in gas state may be any means that detects changes in at least one of the pressure, volume, and temperature of the refrigerant 24 in gas state.

In detecting changes in temperature, the sensor of the detecting means for detecting changes in temperature is preferably disposed in the refrigerant 24 in liquid state in the first housing 14. With this configuration, a rise in the temperature of the coil 10 can be detected faster than transfer of heat corresponding to a change in the temperature of the coil 10 through the space 26 to the refrigerant 28.

The drive units 200, 300, 400, and 500 do not necessarily need to be of a moving magnet type in which the movable element 18 moves, and may be of a moving coil type in which the coil 10 moves. The stage device does not necessarily need to be one that linearly moves the object 2, and may be one that rotationally moves the object 2. Besides being a device for positioning the substrate 810, the stage device may be a device for positioning, for example, an optical element.

The drive units 200, 300, 400, and 500 each are not limited to a drive mechanism mounted on a stage device included in a lithography apparatus, and may be a drive mechanism mounted on other devices which require high-precision positioning. For example, when the lithography apparatus is a semiconductor exposure apparatus, the drive units 200, 300, 400, and 500 may each be a drive mechanism, such as a reaction force canceller, which is capable of reducing reaction force associated with the movement of a masking blade for blocking exposure light or the movement of the stage device. For example, when the lithography apparatus is an imprint apparatus, the drive units 200, 300, 400, and 500 may each be a drive mechanism that drives a mold having a three-dimensional pattern thereon or a supply unit configured to supply an imprint material.

[Article Manufacturing Method]

A pattern formed using the lithography apparatus is temporarily used to manufacture various articles. Examples of the articles include electric circuit elements, optical elements, MEMS elements, recording elements, sensors, and molds. The electric circuit elements may be volatile or nonvolatile semiconductor memories, such as DRAMs, SRAMs, flash memories, or MRAMs, or may be semiconductor elements, such as LSIs, CCDs, image sensors, or FPGAs. The molds may be those used for imprinting.

For manufacture of articles, a substrate having a pattern formed thereon using the lithography apparatus is subjected to etching or ion implantation in a substrate processing step, which is followed by removal of a resist mask. When an exposure apparatus or drawing apparatus is used as the lithography apparatus, development of a resist precedes the processing step described above. A cured resist pattern formed by using an imprint apparatus as the lithography apparatus may be used as a component of at least some of the articles described above. The processing step described above may be followed by known processing steps (e.g., development, oxidation, film deposition, vapor deposition, planarization, resist removal, dicing, bonding, and packaging).

The present invention is not limited to the embodiments described above and various changes and modifications can be made without departing from the spirit and scope of the present invention. The following claims are appended to disclose the scope of the present invention.

This application claims the benefit of Japanese Patent Application No. 2016-038128 filed February 29, 2016, which is hereby incorporated by reference herein in its entirety.

**Claims**

1.  A drive unit comprising:

    an electromagnetic actuator including a magnet and a coil and configured to drive an object by allowing current to flow through the coil;
    containing means for containing a first refrigerant and the coil immersed in the first refrigerant in liquid state, the first refrigerant cooling the coil by evaporating from liquid state;
    condensing means for condensing the first refrigerant in gas state; and
    detecting means for detecting changes in temperature or volume of the first refrigerant,

    wherein the condensing means includes regulating means for regulating a condensation quantity of the first refrigerant on the basis of a result of detection made by the detecting means.

2.  The drive unit according to Claim 1, wherein the regulating means regulates the condensation quantity by regulating heat of the first refrigerant in gas state in at least one of an interior of the containing means and a space communicating with the interior of the containing means.

3.  The drive unit according to Claim 2, wherein the condensing means condenses the first refrigerant existing in gas state in the space.

4.  The drive unit according to Claim 1, wherein the drive unit has a space communicating with an interior of the containing means and changing in volume as a state of the first refrigerant changes; and
    the detecting means detects changes in the volume of the first refrigerant by detecting changes in the volume of the space.

5.  The drive unit according to Claim 4, wherein the space is back-pressured to the predetermined pressure.

6.  The drive unit according to Claim 5, wherein the predetermined pressure is equal to an internal pressure of the containing means during a period in which the coil generates no heat.

7.  The drive unit according to Claim 1, wherein the regulating means is a Peltier element configured to transfer heat in an interior of the containing means to a space not communicating with the interior of the containing means.

8.  The drive unit according to Claim 1, wherein the condensing means condenses the first refrigerant in gas state using a second refrigerant flowing through a system independent of the first refrigerant; and
    the regulating means is at least one of flow rate control means for controlling a flow rate of the second refrigerant and temperature control means for controlling a temperature of the second refrigerant.

9.  The drive unit according to Claim 8, wherein the regulating means is the temperature control means, and increases the condensation quantity by reducing the temperature of the second refrigerant.

10. The drive unit according to Claim 8, wherein the regulating means is the flow rate control means, and increases the condensation quantity per unit time by increasing the flow rate of the second refrigerant.

11. A lithography apparatus comprising:

    a positioning device including the drive unit according to any one of Claims 1 to 10, the positioning device being configured to determine a position of a substrate; and
    a pattern forming unit configured to form a pattern on the substrate.

12. A coil cooling method in which a coil of an electromagnetic actuator, the coil being immersed in a refrigerant in liquid state, is cooled by evaporation of the refrigerant in liquid state, the coil cooling method comprising:

    a detecting step of detecting changes in temperature or pressure of the first refrigerant turned into gas state by the evaporation; and

a condensing step of condensing the first refrigerant in gas state,

wherein the condensing step includes a regulating step of regulating a condensation quantity of the first refrigerant on the basis of a result of detection made in the detecting step.

13. An article manufacturing method comprising:

a forming step of forming a pattern on a substrate using the lithography apparatus according to Claim 11; and
a processing step of processing the substrate having the pattern formed thereon in the forming step.

# FIG. 1

(a)

(b)

# FIG. 2

# FIG. 3

## FIG. 4

400

## FIG. 5

500

# FIG. 6

**EP 3 425 452 A1**

## INTERNATIONAL SEARCH REPORT

| International application No. |
|---|
| PCT/JP2017/006096 |

A. CLASSIFICATION OF SUBJECT MATTER
*G03F7/20*(2006.01)i, *H01L21/68*(2006.01)i, *H02K9/19*(2006.01)i

According to International Patent Classification (IPC) or to both national classification and IPC

B. FIELDS SEARCHED

Minimum documentation searched (classification system followed by classification symbols)
G03F7/20-7/24, H01L21/027, H01L21/30, H02K9/00-9/28, H02K41/00-41/06

Documentation searched other than minimum documentation to the extent that such documents are included in the fields searched
Jitsuyo Shinan Koho          1922-1996   Jitsuyo Shinan Toroku Koho   1996-2017
Kokai Jitsuyo Shinan Koho    1971-2017   Toroku Jitsuyo Shinan Koho   1994-2017

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| Y<br>A | JP 2013-105815 A (Nikon Corp.),<br>30 May 2013 (30.05.2013),<br>claims 1, 11; paragraphs [0031] to [0041]; fig. 1, 3 to 4<br>(Family: none) | 1-3,7-13<br>4-6 |
| Y<br>A | JP 2002-291219 A (Canon Inc.),<br>04 October 2002 (04.10.2002),<br>paragraph [0024]; fig. 1<br>& US 2002/0140298 A1<br>paragraphs [0051] to [0052]; fig. 1A, 1B | 1-3,7-13<br>4-6 |
| Y<br>A | JP 2004-31673 A (Nikon Corp.),<br>29 January 2004 (29.01.2004),<br>paragraphs [0016], [0018]; fig. 1<br>(Family: none) | 1-3,7-13<br>4-6 |

[X] Further documents are listed in the continuation of Box C.    [ ] See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search<br>30 March 2017 (30.03.17) | Date of mailing of the international search report<br>11 April 2017 (11.04.17) |
|---|---|
| Name and mailing address of the ISA/<br>Japan Patent Office<br>3-4-3,Kasumigaseki,Chiyoda-ku,<br>Tokyo 100-8915,Japan | Authorized officer<br><br>Telephone No. |

Form PCT/ISA/210 (second sheet) (January 2015)

17

**INTERNATIONAL SEARCH REPORT**

| International application No. |
| --- |
| PCT/JP2017/006096 |

C (Continuation).   DOCUMENTS CONSIDERED TO BE RELEVANT

| Category* | Citation of document, with indication, where appropriate, of the relevant passages | Relevant to claim No. |
| --- | --- | --- |
| Y<br>A | JP 2003-133211 A  (Canon Inc.),<br>09 May 2003 (09.05.2003),<br>paragraphs [0004], [0022] to [0023], [0026];<br>fig. 5<br>(Family: none) | 7-11,13<br>1-6,12 |
| Y<br>A | JP 2005-142283 A  (Nikon Corp.),<br>02 June 2005 (02.06.2005),<br>paragraphs [0021], [0035] to [0036], [0059] to<br>[0060]; fig. 1 to 2<br>(Family: none) | 7-11,13<br>1-6,12 |
| A | JP 2002-78314 A  (Nikon Corp.),<br>15 March 2002 (15.03.2002),<br>paragraphs [0022] to [0044]; fig. 1 to 4, 6 to<br>8<br>(Family: none) | 1-13 |
| A | JP 2005-64391 A  (Canon Inc.),<br>10 March 2005 (10.03.2005),<br>paragraph [0054]<br>(Family: none) | 1-13 |

Form PCT/ISA/210 (continuation of second sheet) (January 2015)

**EP 3 425 452 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006006050 A

- JP 2016038128 A